# EUROPEAN PATENT APPLICATION

(11) **EP 0 817 276 A1**
(43) Date of publication of application: **07.01.1998**
(21) Application number: 95912464.5
(22) Date of filing: 17.03.1995
(51) Int. Cl.: H01L 29/737

(54) **SEMICONDUCTOR DEVICE AND PRODUCTION METHOD THEREFOR**

(71) Applicant: HITACHI, LTD., Chiyoda-ku, Tokyo 101 (JP); Hitachi, Ulsi Engineering Corp., Tokyo 187 (JP)
(72) Inventor: HIRATA, Koji Puchihaitsu Jousui Room 203, Kodaira-shi Tokyo 187 (JP); TANOUE, Tomonori, Tokyo 194 (JP); MASUDA, Hiroshi, Tokyo 187 (JP); UCHIYAMA, Hiroyuki, Tokyo 186 (JP); MOCHIZUKI, Kazuhiro Hitachi Oowada Apato Room D302, Tokyo 192 (JP)
(74) Representative: Calderbank, Thomas Roger
(86) International application number: JP9500485
(87) International publication number: WO9629740

(57) **Abstract**

The present invention relates to a contact structure not only for a semiconductor device having a hetero-junction bipolar transistor or a hetero-insulated gate field effect transistor but also for semiconductor devices at large.

In a semiconductor layer of a polycrystalline or amorphous undoped III-V compound semiconductor or an alloy thereof is formed a through hole for contact of a size permitting exposure of at least part of a first conductor layer and a dielectric Si alloy layer present around the first conductor layer, and a second conductor layer is formed within the through hole so as to contact the first conductor layer.

Since the semiconductor layer can be subjected to a selective dry etching for the dielectric Si alloy layer, the dielectric Si alloy layer is not etched at the time of forming the above through hole in the semiconductor layer, whereby an electric short-circuit of the second conductor layer with a single crystal semiconductor layer which underlies the dielectric Si alloy layer can be prevented.

## Description

### Technical Field

The present invention relates to semiconductor devices at large, including bipolar transistors and field effect transistors, as well as a method for manufacturing the same.

### Background Art

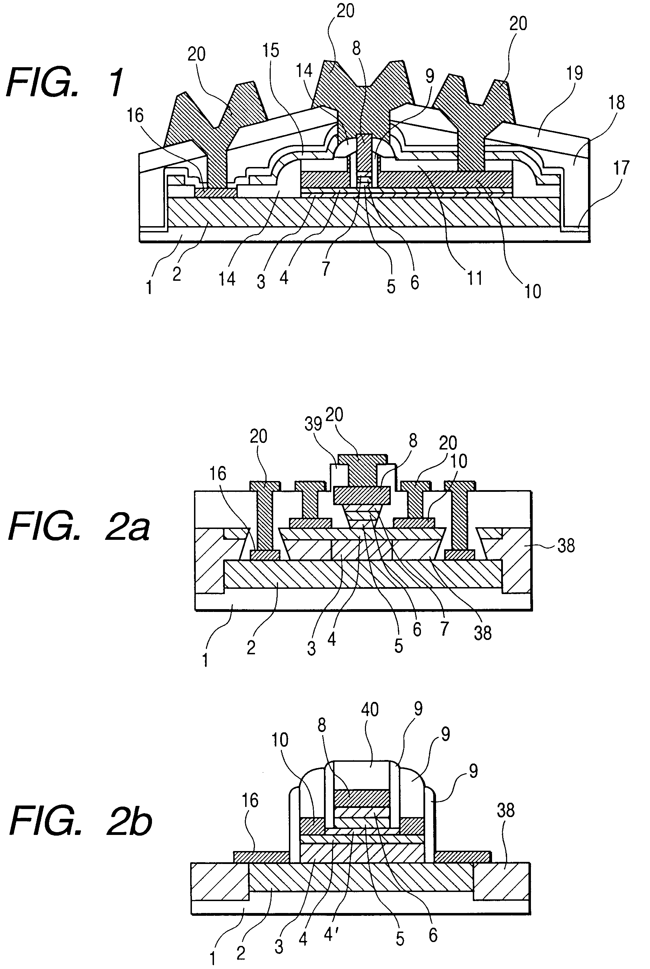

A conventional hetero-junction bipolar transistor using a Group III-V compound semiconductor is described, for example, in National Technical Report Vol. 39 No. 6 (Dec. 1993), pp. 729-735 (the first prior art). Its sectional structure is illustrated in Fig. 2(a). On a GaAs substrate 1 are formed a heavily doped n-type GaAs sub-collector layer 2, an n-type GaAs collector layer 3, a heavily doped p-type GaAs base layer 4, an n-type AlGaAs emitter layer 5, a heavily doped n-type InGaAs cap layer 6 for forming an ohmic contact, and a heavily doped n-type InGaAs layer 7. An emitter electrode 8, a base electrode 10 and a collector electrode 16 are formed on exposed emitter layer, base layer and sub-collector layer, respectively. The reference numeral 38 denotes an area which has been rendered high in resistance by proton implantation. According to the structure of this device, the area of the emitter electrode is larger than that of an emitter electrode contact hole formed by an SiN layer 39 which is used for connection with a wiring metal 20.

Another example of a hetero-junction bipolar transistor using a Group III-V compound semiconductor is described in IEEE Electron Device Letters EDL-8 (1987), pp. 246-248 (the second prior art). Its sectional structure is illustrated in Fig. 2(b). On a GaAs substrate 1 are formed a heavily doped n-type GaAs sub-collector layer 2, an n-type GaAs collector layer 3, a heavily doped p-type GaAs base layer 4, an undoped GaAs base spacer layer 4', an n-type AlGaAs emitter layer 5, and a heavily doped n-type GaAs cap layer 6 for forming an ohmic contact. An emitter electrode 8, a base electrode 10 and a collector electrode 16 are formed on exposed emitter layer, base layer and sub-collector layer, respectively. The reference numeral 9 denotes SiO₂ side walls, numeral 38 denotes an area which has been rendered high in resistance by proton implantation, and numeral 40 denotes an SiO₂ film. In this device, the outer periphery of mesa portion of the base layer 4 and collector layer 3 is of the same structure as the outer periphery of the base electrode 10.

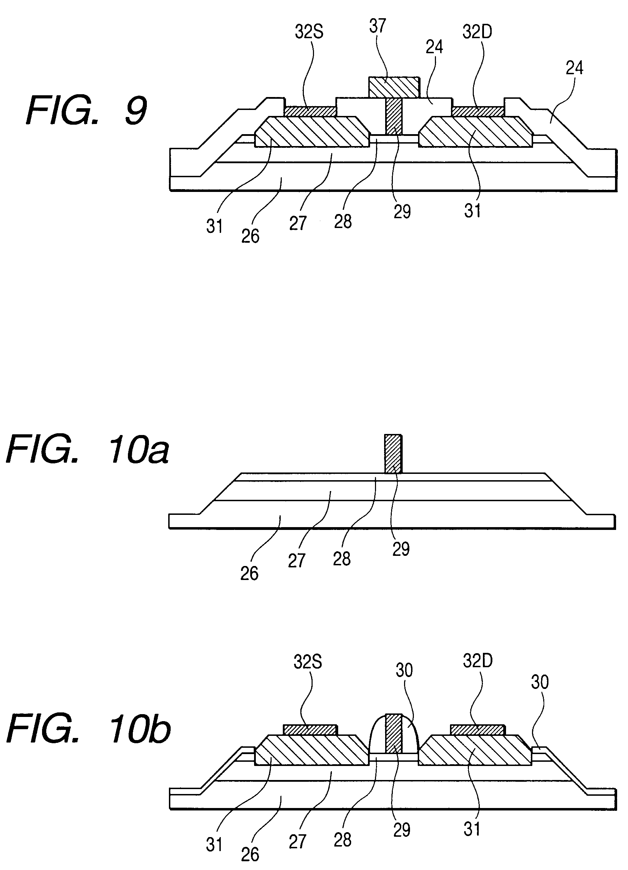

Further, a conventional hetero-insulated gate field effect transistor is described, for example, in Japanese Patent Laid Open No. 283433/93 (the third prior art). The hetero-insulated gate field effect transistor indicates a gate field effect transistor of a structure in which a layer of a larger energy band gap than a channel layer is sandwiched in between the channel layer and a Schottky gate electrode. Its sectional structure is illustrated in Fig. 9. In the same figure, the numeral 26 denotes a single crystal semiconductor substrate, numeral 31 denotes a heavily doped n-type GaAs layer, numeral 28 denotes a channel layer comprising n-type GaAs layer, undoped AlGaAs layer and undoped GaAs layer, and numeral 24 denotes an insulating layer between SiO₂ layers. In this device, a low-resistance metal 37 is laminated onto a gate electrode 29 formed of WSi to reduce the gate resistance.

### Disclosure of Invention

For attaining a very high speed of a hetero-junction bipolar transistor, it is effective to diminish the base resistance, emitter-base capacitance and base-collector capacitance. The capacitances each increase in proportion to the junction area. For the reduction of capacitance, reducing the size of each pattern itself of emitter, etc. and shortening of the distance between adjacent patterns are effective.

In the first prior art described above, however, it has been found that if the area of the emitter electrode 8 is made finer than the area of the emitter electrode contact hole, the base electrode 10 is exposed by etching at the time of forming the emitter elctrode contact hole and that short-circuit between the emitter and the base is caused by the wiring metal 20. Thus, a limit is encountered in the reduction of emitter-base and base-collector parasitic capacitance by reducing the size of the device.

In the second prior art described above it has been found that if the outer periphery of mesa portion of the base layer 4 and collector layer 3 is made small, the base electrode area is also required to be made small, thus resulting in increase of the base electrode resistance.

In the third prior art referred to above it has been found that at the time of etch back of the insulating layer 24 between SiO₂ layers for exposing the gate electrode 29, the etching of the insulating layer 24 proceeds to an excessive degree and reaches the source or drain region and that consequently the source or drain region and the gate electrode 29 are short-circuited when the low-resistance metal layer 37 is formed on the gate electrode 29.

It is the first object of the present invention to solve the problem of short-circuit under the above-mentioned conditions with respect to semiconductor devices at large without limiting to semiconductor devices having hetero-junction bipolar transistors and hetero-insulated gate field effect transistors. More specifically, it is the first object of the invention to provide a semiconductor device of a structure comprising a first conductor layer and a second conductor layer, the first conductor layer being formed on a single crystal semiconductor layer, with a first dielectric Si alloy layer being formed on each side face of the first conductor layer, and the second conductor layer being formed on and in contact with the first dielectric Si alloy layer present around the first conductor layer. It is thereby intended to prevent an electric short-circuit between the second conductor layer and the single crystal semiconductor layer.

It is the second object of the present invention to reduce the area of base mesa portion without increase of the base electrode resistance in a semiconductor device having a hetero-junction bipolar transistor.

The first object mentioned above can be achieved by forming on the first dielectric Si alloy layer a first semiconductor layer of a polycrystalline or amorphous undoped III-V compound semiconductor, or an alloy thereof, having a through hole to which is exposed at least part of the first conductor layer or the first dielectric Si alloy layer present around the first conductor layer, and then forming second conductor layer within the through hole.

The first object can also be achieved by a semiconductor device manufacturing method comprising the steps of forming a first conductor layer on a single crystal semiconductor layer, forming a first dielectric Si alloy layer on each side face of the first conductor layer so that the upper surface of the first conductor layer is exposed, forming on the first dielectric Si alloy layer and the first conductor layer a first semiconductor layer of a polycrystalline or amorphous undoped III-V compound semiconductor or an alloy thereof and a second dielectric Si alloy layer in this order, forming in the second dielectric Si alloy layer a first through hole which reaches the first semiconductor layer in accordance with a selective dry etching method for the first semiconductor layer, using a reactive gas, forming in the first semiconductor layer a second through hole which reaches at least part of the first conductor layer and the first dielectric Si alloy layer present around the first conductor layer, in accordance with a selective dry etching method for the first conductor layer and the first dielectric Si alloy layer, using a reactive gas and using as an etching mask the second dielectric Si alloy layer which has the first through hole, and forming a second conductor layer within a through hole constituted by the first and second through holes so as to contact the first conductor layer.

The foregoing second object of the invention can be attained by a semiconductor device having a structure of a bipolar transistor wherein sub-collector region, collector region, base region and emitter region are laminated in this order, the collector region and the base region being smaller than the sub-collector region, the emitter region being smaller than the collector region and the base region, further having a dielectric layer formed on the sub-collector, collector and base regions and having a through hole formed on the base region, a base lead-out semiconductor layer of the same conductivity type as the base region, the base lead-out semiconductor layer being formed in contact with the base region within the through hole of the dielectric layer, and a base electrode formed in contact with the base lead-out semiconductor layer and extending onto the dielectric layer.

The first semiconductor layer of a polycrystalline or amorphous undoped III-V compound semiconductor or an alloy thereof, which layer is introduced for achieving the foregoing first object, can undergo a selective dry etching between it and the first dielectric Si alloy layer, and therefore the first dielectric Si alloy layer is not etched when forming a through hole in the first semiconductor layer. Thus, it is possible to prevent an electric short-circuit between the second conductor layer and the single crystal semiconductor layer.

By introducing the second dielectric Si alloy layer, the wiring capacity can be decreased structurally, while from the standpoint of manufacture a step height on the device surface can be reduced, thus facilitating the formation of wire.

The first semiconductor layer becomes a polycrystalline or amorphous layer or a layer of an alloy thereof, depending on the layer forming temperature. From low to high layer forming temperatures there appear amorphous, mixed crystal, and polycrystal, in this order. Also at a sub-zero temperature it is possible to form the first semiconductor layer. The lower the layer forming temperature, the higher the resistivity of the first semiconductor layer. From this viewpoint the layer formation at a low temperature is desirable. In the low-temperature formation, however, the water content of the film becomes large, and therefore the lower limit of the layer forming temperature is determined while taking the film quality into account. As to the upper limit of the layer forming temperature, 400°C or so is desirable taking the deterioration in characteristics of the device into account.

Further, if the etching selectivity between the semiconductor layer of a polycrystalline or amorphous III-V compound semiconductor or an alloy thereof and the dielectric Si alloy layer is utilized, there can be realized in high controllability a structure wherein the semiconductor layer having a through hole is formed on the dielectric Si alloy.

The structure with a dielectric layer formed under the base electrode, which is introduced for achieving the second object, permits reduction of the area of base mesa portion without causing an increase of the base electrode resistance because it is not required to reduce the base electrode area even when the base mesa region is made small. Besides, it is possible to diminish the base-collector capacitance.

### Brief Description of Drawings

Fig. 1 is a structural sectional diagram of a hetero-junction bipolar transistor of Example 1 in the present invention;
Figs. 2(a) and (b) are structural sectional diagrams of conventional hetero-junction bipolar transistors;
Fig. 3 is a manufacturing process diagram for the hetero-junction bipolar transistor of Example 1;
Fig. 4 is a manufacturing process diagram for a hetero-junction bipolar transistor of Example 2 in the present invention;
Fig. 5 is a manufacturing process diagram for a hetero-junction bipolar transistor of Example 3 in the present invention;
Fig. 6 is a manufacturing process diagram for a hetero-junction bipolar transistor of Example 4 in the present invention;
Fig. 7 is a circuit diagram of a differential amplifier circuit of Example 5 in the present invention;
Fig. 8 is a circuit layout diagram of the differential amplifier circuit of Example 5;
Fig. 9 is a structural sectional diagram of a conventional hetero-insulated gate field effect transistor;
Fig. 10 is a manufacturing process diagram for a hetero-insulated gate field effect transistor of Example 6 in the present invention;
Fig. 11 is a circuit diagram of a static type random access memory cell of Example 7 in the present invention; and
Fig. 12 is a circuit diagram of a dynamic type random access memory cell of Example 8 in the present invention.

### Best Mode for Carrying Out the Invention

The present invention will be described in more detail hereinunder by way of working examples thereof.

### Example 1

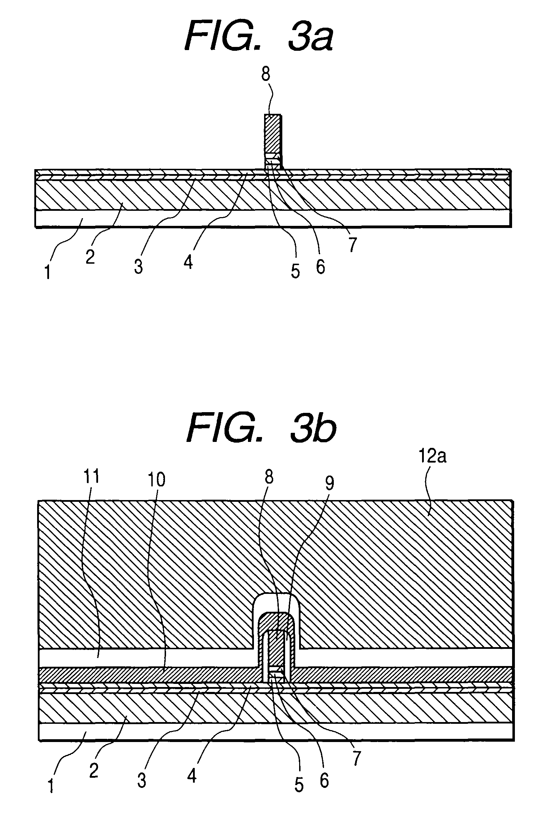

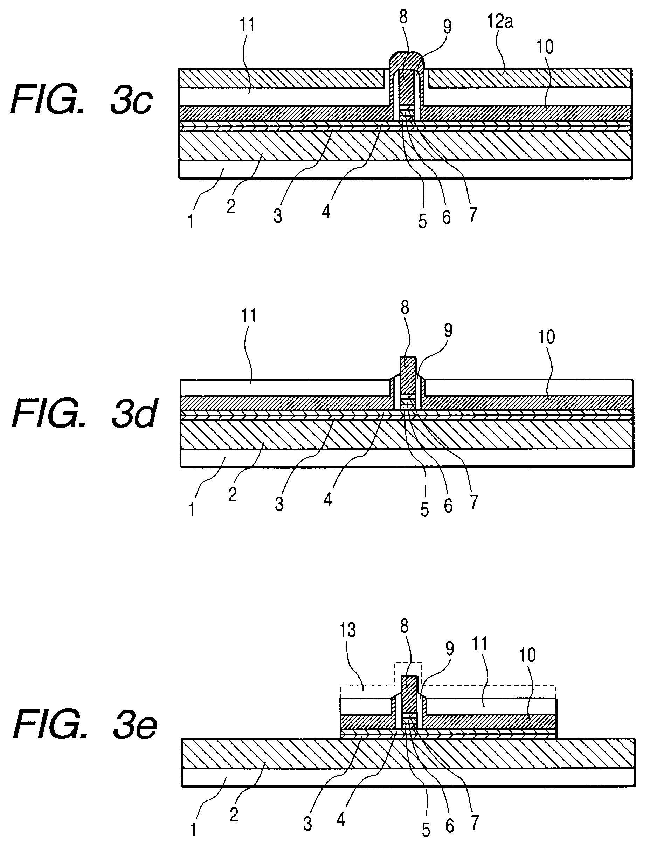

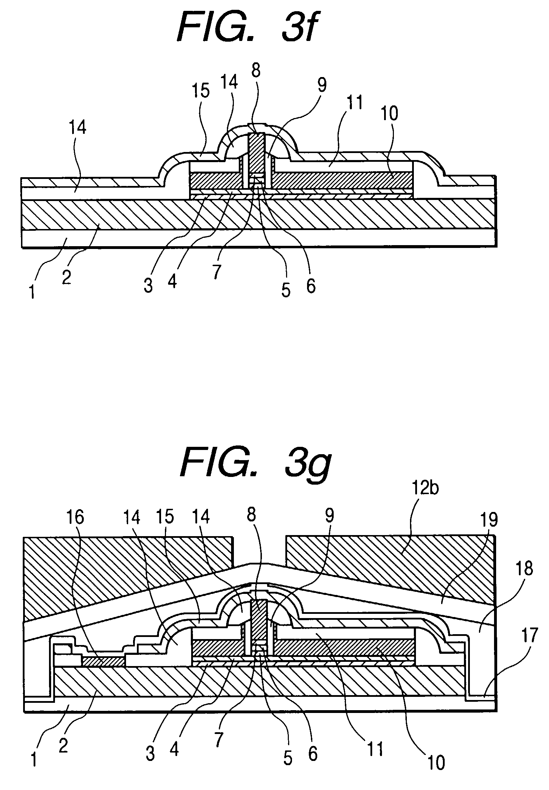

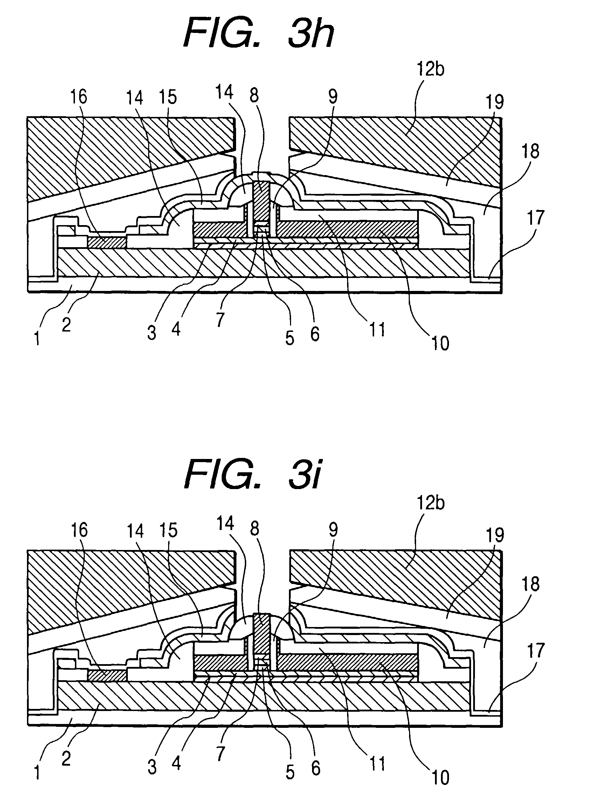

An AlGaAs/GaAs hetero-junction bipolar transistor in Example 1 of the present invention will be described below with reference to Figs. 1 and 3. In this Example, an amorphous undoped GaAs layer 15 is formed in a dielectric interlayer area.

First, a heavily doped n-type GaAs sub-collector layer 2 (Si concentration 5x10¹⁸/cm³, thickness 500 nm), an n-type GaAs collector layer 3 (Si concentration 5x10¹⁶/cm³, thickness 150 nm), a heavily doped p-type GaAs base layer 4 (C concentration 4x10¹⁹/cm³, thickness 50 nm), an n-type AlGaAs emitter layer 5 (AlAs mole ratio 0.3, Si concentration 1x10¹⁸/cm³, thickness 50 nm), a heavily doped n-type GaAs cap layer 6 for forming an emitter ohmic contact (Si concentration 5x10¹⁸/cm³, thickness 150 nm), and a heavily doped n-type InGaAs cap layer 7 (Si concentration 5x10¹⁸/cm³, thickness 50 nm), were formed by epitaxial growth on a GaAs(100) substrate 1. Subsequently, W was deposited 600 nm and a W emitter electrode 8 having a width of 0.3 µm was formed by photolithography using a phase-shifting mask and ECR dry etching using an F-containing gas. Next, with the emitter electrode 8 as mask, the InGaAs cap layer 7, GaAs cap layer 6 and emitter layer 5 were subjected to an isotropic etching in accordance with the ECR method (gas ratio Cl₂/CH₄ = 7/3sccm, etching pressure 36mPa, µ wavepower 700W, RF power 50W, substrate temperature 25°C) to expose the base layer 4. [Fig. 3(a)]

Then, SiO₂ side walls 9 (side wall length 0.1 µm) were formed by the deposition of SiO₂ and dry etching. Subsequently, Pt, Ti, Mo, Ti, Pt, and Au, as materials of a base electrode 10 were deposited 300 nm in this order by directional evaporation, followed by deposition of SiO₂ film 11, application of photoresist 12a and planarization. [Fig. 3(b)]

Thereafter, the photoresist 12a and the SiO₂ film 11 were etched back to expose a film of the materials for the base electrode 10 formed on the emitter electrode 8. [Fig. 3(c)]

Next, the exposed film of the materials for the base electrode 10, including part of the portion deposited on side faces of the SiO₂ side walls 9, was ethced off by ion milling. [Fig. 3(d)]

Then, an SiO₂ film pattern 13 was formed by the deposition of SiO₂ and dry etching using a photoresist as mask. Further, with the SiO₂ film pattern 13 as mask, the base electrode 10, base layer 4 and collector layer 3 were subjected to ion milling to expose the sub-collector layer 2. [Fig. 3(e)]

Subsequently, SiO₂ side walls 14 covering the exposed base electrode 10 were formed by the deposition of SiO₂ and dry etching. Then, within a molecular beam epitaxy system, undoped GaAs was deposited to a thickness of 50 nm at a substrate heating temperature of 120°C. The crystal structure of the resulting layer 15 was amorphous. [Fig. 3(f)]

Next, the sub-collector layer 2 was subjected to dry etching, allowing inter-device isolation to take place. Subsequently, an AuGe collector electrode 16 was formed by the lift-off method.

Thereafter, SiO₂ films 17, 18 and 19 were deposited successively to form a dielectric interlayer area, of which the SiO₂ film 18 is for diminishing the step height and was formed by coating. The SiO₂ films 17 and 19 serve to prevent the entry of water into the SiO₂ film 18. Next, there was formed a photoresist mask 12b for forming an emitter electrode contact hole. [Fig. 3(g)]

Then, using a mixed etching solution of HF and H₂O, the SiO₂ film 19 was subjected to isotropic etching. Subsequently, the SiO₂ film 19, coated SiO₂ film 18, and SiO₂ 17 were subjected to dry etching by the RIE method using C₂F₆ gas and CHF₃ gas in a selective and an isotropic manner for the undoped GaAs layer 15. [Fig. 3(h)]

Next, the undoped GaAs layer 15 was subjected to dry etching by the ECR method using SiCl₄ gas in a selective and an isotropic manner for the SiO₂ film 14 and emitter electrode 8 to expose the upper surface of the emitter electrode 8. [Fig. 3(i)]

Likewise, also on the base electrode 10 and the collector electrode 16 was deposited wiring metal 20 after the formation of a contact hole, and then wiring was made by milling, to fabricate a hetero-junction bipolar transistor. (Fig. 1)

According to this Example, a hetero-junction bipolar transistor having an emitter area of 0.3 µm in width can be produced in high process yield. As a result, in comparison with the device having an emitter region width of 1 µm, the emitter-base parasitic capacitance can be diminished to about one third and the base-collector parasitic capacitance diminished to about two thirds, and it is possible to fabricate a super high-speed hetero-junction bipolar transistor having a maximum oscillation frequency about 1.2 times that of the conventional device.

### Example 2

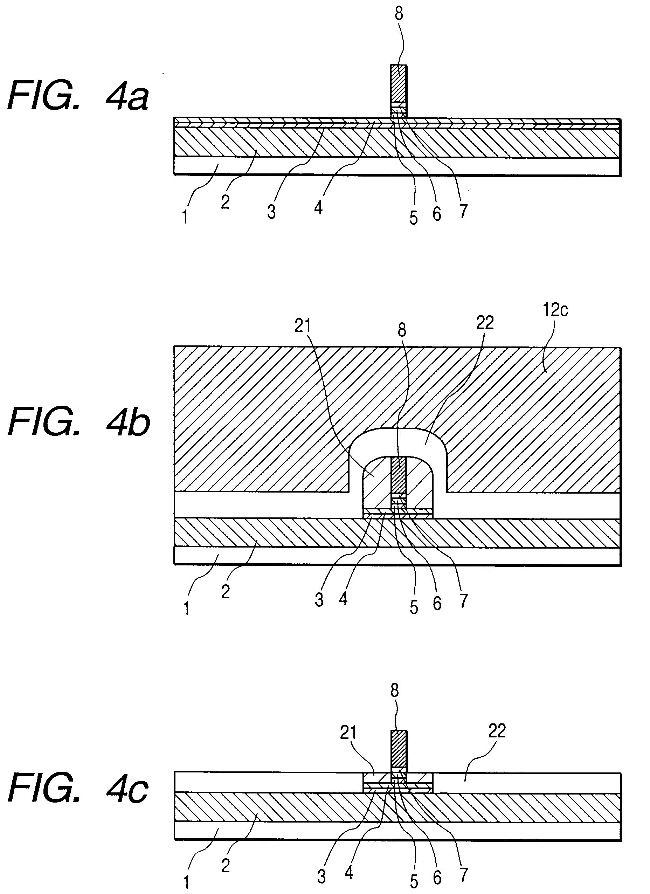

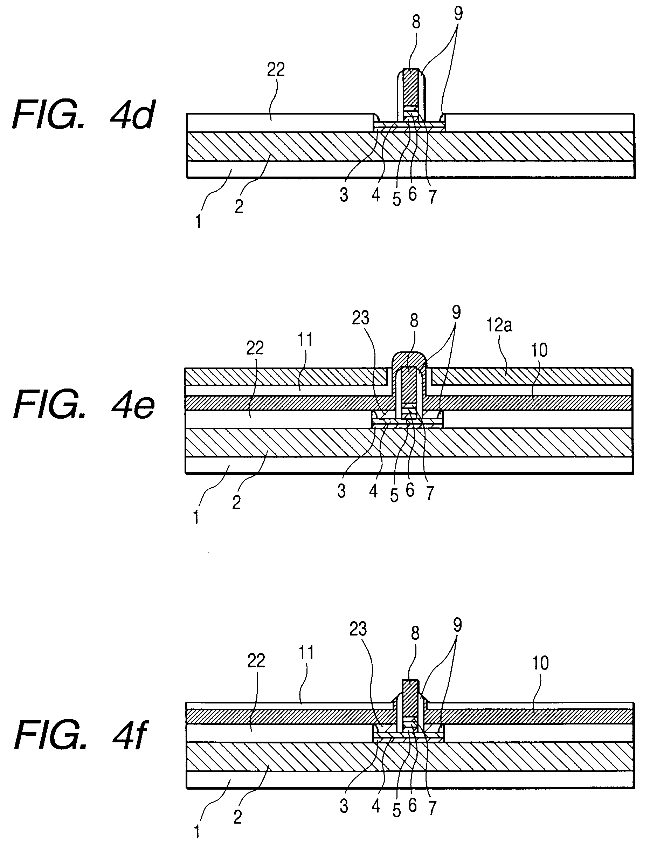

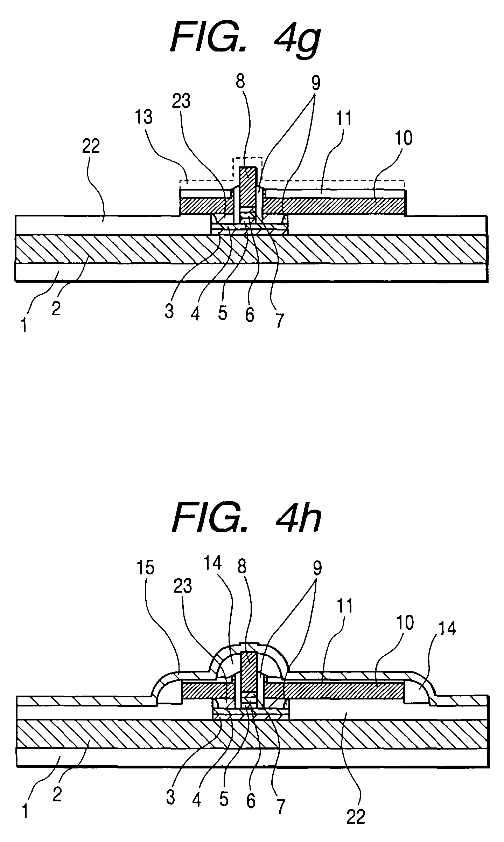

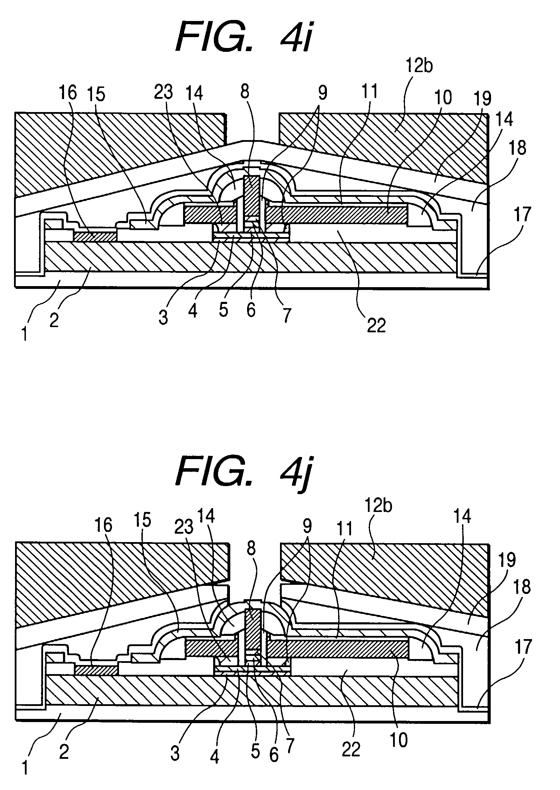

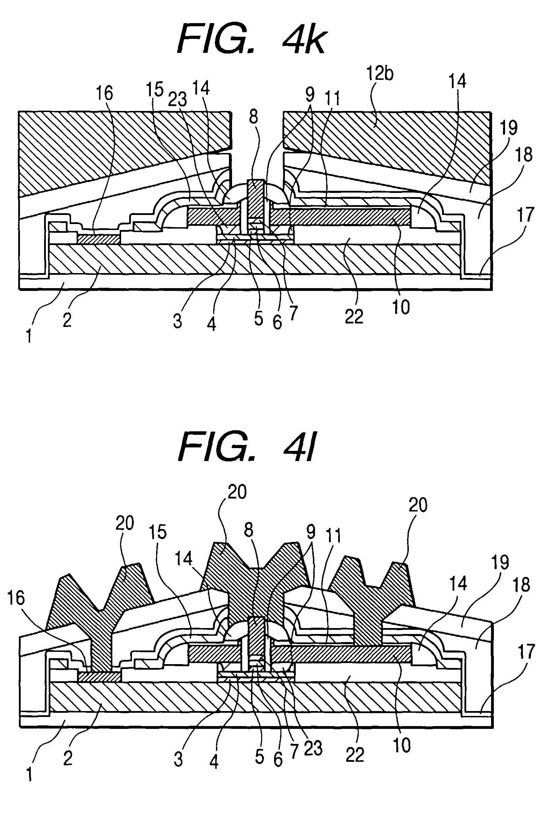

An AlGaAs/GaAs hetero-junction bipolar transistor in Example 2 of the present invention will now be described with reference to Fig. 4. In this Example, an amorphous undoped GaAs layer 15 is formed in the dielectric interlayer area. Further, a heavily doped p-type GaAs layer 23 for suppressing the increase of the electrode contact resistance is formed between the base layer and the base electrode, and an SiO₂ layer 22 for decreasing the base-collector capacitance is formed in the parasitic collector portion included in the collector region.

First, a heavily doped n-type GaAs sub-collector layer 2 (Si concentration 5x10¹⁸/cm³, thickness 500 nm), an n-type GaAs collector layer 3 (Si concentration 5x10¹⁶/cm³, thickness 150 nm), a heavily doped p-type GaAs base layer 4 (C concenration 4x10¹⁹/cm³, thickness 50 nm), an n-type AlGaAs emitter layer 5 (AlAs mole ratio 0.3, Si concentration 1x10¹⁸/cm³, thickness 50 nm), an n-type GaAs cap layer 6 for forming an emitter ohmic contact (Si concetration 5x10¹⁸/cm³, thickness 150 nm), and a heavily doped n-type InGaAs cap layer 7 (Si concentration 5x10¹⁸/cm³, thickness 50 nm), were formed by epitaxial growth on a GaAs (100) substrate 1. Subsequently, W was deposited 600 nm and a W emitter electrode 8 having a width of 0.3 µm was formed by photolithography using a phase-shifting mask and ECR dry etching using an F-containing gas. Then, with the emitter electrode 8 as mask, the InGaAs cap layer 7, GaAs cap layer 6 and emitter layer 5 were subjected to an isotropic etching in accordance with the ECR method (gas ratio Cl₂/CH₄ = 7/3sccm, etching pressure 36mPa, µ wave power 700W, RF power 50W, substrate temperature 25°C) to expose the base layer 4. [Fig. 4(a)]

Then, SiN side walls 21 (side wall length 0.5 µm) were formed by the deposition of SiN and dry etching. Further, with the emitter electrode 8 and the SiN side walls 21 as mask, the base layer 4 and the collector layer 3 were subjected to ECR dry etching an isotropically to expose the sub-collector layer 2. Hereafter, SiO₂ film 22 was formed by deposition, followed by application of a photoresist 12c and planarization. [Fig. 4(b)]

Next, the photoresist 12c and the SiO₂ film 22 were etched back until the thickness of the SiO₂ film 2 was 300 nm. At this time, the base layer 4 is not exposed. [Fig. 4(c)]

Then, the SiN side walls 21 were etched to expose the base layer 4 by means of a plasma etching system and using an F-containing gas. Thereafter, SiO₂ side walls 9 were formed on the side faces of emitter portion 5, 6, 7, 8 and SiO₂ film 22 by the deposition of SiO₂ and dry etching. The SiO₂ side walls 9 are 0.1 µm long and the base layer 4 is exposed sufficiently.
[Fig. 4(d)]

Next, the substrate was introduced into a metal-organic chemical vapor deposition system and selective epitaxial growth of a heavily doped p-type GaAs layer 23 (C concentration 4x10²⁰/cm³, thickness 150 nm) was allowed to take place. Subsequently, Pt, Ti, Mo, Ti, Pt, and Au, as materials of a base electrode 10 were deposited 300 nm in this order by directional evaporation, followed by deposition of SiO₂ film 11, application of photoresist 12a and planarization.

Thereafter, the photoresist 12a and the SiO₂ film 11 were etched back to expose a film of the materials for the base electrode 10 formed on the emitter electrode 8. [Fig. 4(e)]

Next, the exposed film of the materials for the base electrode 10, including part of the portion deposited on side faces of the SiO₂ side walls 9, were etched off by ion milling. [Fig. 4(f)]

Then, an SiO₂ film pattern 13 was formed by the deposition of SiO₂ and dry etching using a photoresist as mask. Further, with the SiO₂ film pattern 13 as mask, the base electrode 10 was subjected to ion milling. [Fig. 4(g)]

Subsequently, SiO₂ side walls 14 covering the exposed base electrode 10 were formed by the deposition of SiO₂ and dry etching. Then, the substrate was introduced into a molecular beam epitaxy system and undoped GaAs was deposited to a thickness of 50 nm at room temperature without heating the substrate. The crystal structure of the resulting layer 15 was amorphous. [Fig. 4(h)]

Next, the sub-collector layer 2 was subjected to dry etching to effect inter-device isolation, followed by formation of an AuGe collector electrode 16 in accordance with the lift-off method. Thereafter, SiO₂ films were deposited successively to form a dielectric interlayer area. The SiO₂ was is for decreasing the step height and it was formed by coating. The SiO₂ films 17 and 19 serve to prevent the entry of water into the SiO₂ film. Then, a photoresist mask 12b for forming an emitter electrode contact hole was formed. [Fig. 4(i)]

Next, using a mixed etching solution of HF and H₂O, the SiO₂ film 19 was subjected to isotropic etching. Subsequently, the SiO₂ film 19, coated SiO2 film 18 and SiO₂ film 7 were subjected to dry etching by the RIE method using C₂F₆ gas and CHF₃ gas in a selective and an isotropic manner for the undoped GaAs layer 15. [Fig. 4(j)]

Then, the undoped GaAs layer 15 was subjected to dry etching by the ECR method using SiCl₄ gas in a selective and an isotropic manner for the SiO2 film 14 and emitter electrode 18. [Fig. 4(k)]

Likewise, wiring metal 20 was deposited and wired by milling on the base electrode 10 and collector electrode 16 after the formation of a contact hole, to fabricate a hetero-junction bipolar transistor. [Fig. 4(l)]

According to this Example, the GaAs layer 23 having a C concentratin of 4x10²⁰/cm³ is formed in the base lead-out area to suppress the increase in contact resistance of the base electrode, and the SiO₂ film 22 low in specific inductive capacity is formed in the parasitic collector region to diminish the base-collector junction area. Therefore, it is possible to fabricate a super high-speed hetero-junction bipolar transistor decreased to about one third in base-collector parasitic capacitance and increased to about 1.7 times in maximum oscillation frequency as compared with the structure of Example 1. Further, the amorphous undoped GaAs layer 15 formed in the dielectric interlayer area permits such hetero-junction bipolar transistor to be fabricated in a high process yield without causing the problems of emitter-base short-circuit and breaking of the wiring metal.

### Example 3

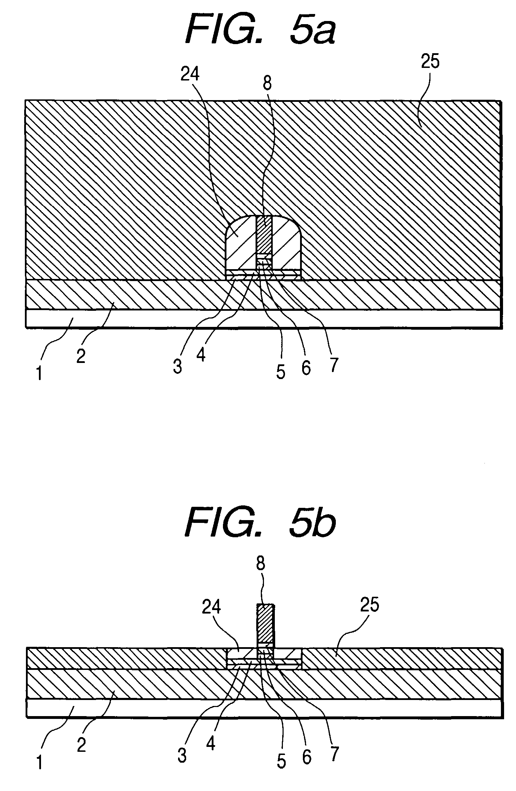

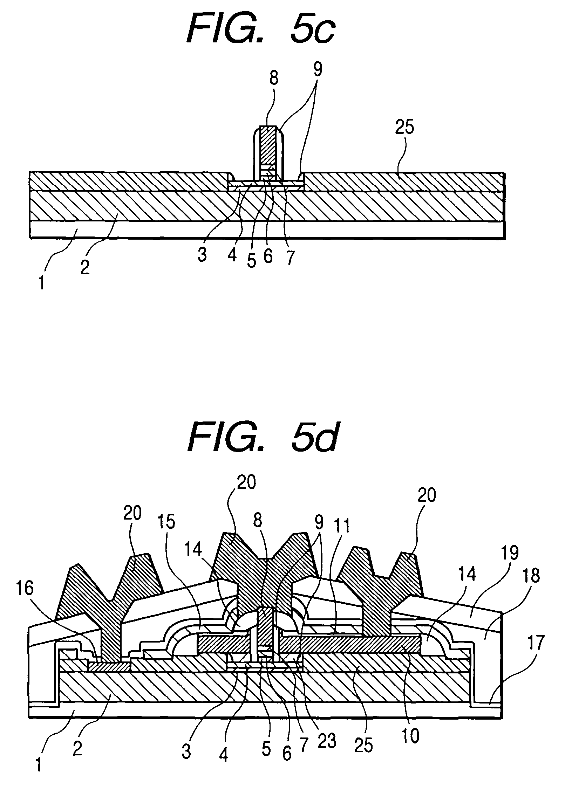

An AlGaAs/GaAs hetero-junction bipolar transistor in Example 3 of the present invention will now be described with reference to Figs. 4(a), 4(e) to 4(k) and Fig. 5. In this Example, a polyimide resin film 25 still lower in specific inductive capacity than the SiO₂ film 22 used in Example 2 is formed in the parasitic collector region.

The manufacturing method of this Example is basically the same as that of Example 2 (Fig. 4), with a difference residing in that Figs. 4(b) to 4(d) are replaced by Figs. 5(a) to 5(c).

First, SiO₂ was deposited on the whole surface of the structure shown in Fig. 4(a), and SiO₂ side walls 24 (side wall length 0.5 µm) were formed by dry etching. Subsequently, with the SiO₂ side walls 24 and the emitter electrode 8 as mask, the base layer 4 and the collector layer 3 were subjected to dry etching by the ECR method in an anisotropic manner to expose the sub-collector layer 2. Then, a polyimide resin was applied to the whole surface until the surface became flat, to afford a polyimide resin film 25. [Fig. 5(a)]

Next, the polyimide resin film 25 was etched back to a thickness of 300 nm. At this time, the base layer 4 is not exposed. [Fig. 5(b)]

Then, the SiO₂ side walls 24 were etched off using a mixed etching solution of HF and H₂O to expose the base layer 4. Thereafter, SiO₂ side walls 9 were formed on side faces of emitter portions 5, 6, 7, 8 and the polyimide resin film 25 by the deposition of SiO₂ and dry etching. The SiO₂ side walls 9 were 0.1 µm long and the base layer 4 was exposed sufficiently. [Fig. 5(c)]

Then, the same manufacturing steps as in Figs. 4(e) to 4(k) were followed to fabricate a hetero-junction bipolar transistor, whose completed state is illustrated in Fig. 5(d).

According to this Example, since the polyimide resin film 25 lower in specific inductive capacity than the SiO₂ film 22 is formed in the parasitic collector region, it is possible to fabricate a super high-speed hetero-junction bipolar transistor decreased in base-collector parasitic capacitance to about seven ninths and increased in maximum oscillation frequency to about 1.1 times as compared with the structure of Example 2. Further, the amorphous undoped GaAs layer 15 formed in the dielectric interlayer area permits such hetero-junction bipolar transistor to be fabricated in a high process yield without causing the problems of emitter-base short-circuit and breaking of the wiring metal.

### Example 4

An AlGaAs/GaAs hetero-junction bipolar transistor in Example 4 of the present invention will be described below with reference to Figs. 4(a), 4(e) to 4(k), 5(a) to 5(c) and 6(a), 6(b).

This Example is characterized by including the step of removing the sub-collector layer 2 from the portion where the base electrode 10 is formed, before the application step of the polyimide resin film 25 illustrated in Fig. 5(a) in connection with Example 3. More specifically, this embodiment is characterized by forming SiO₂ side walls 24 (side wall length 0.5 µm), base layer 4 and collector layer 3 on the structure of Fig. 4(a) in the same way as in Example 3, thereafter forming a resist mask 12d partially and removing the sub-collector layer 2, allowing the substrate 1 to be exposed.

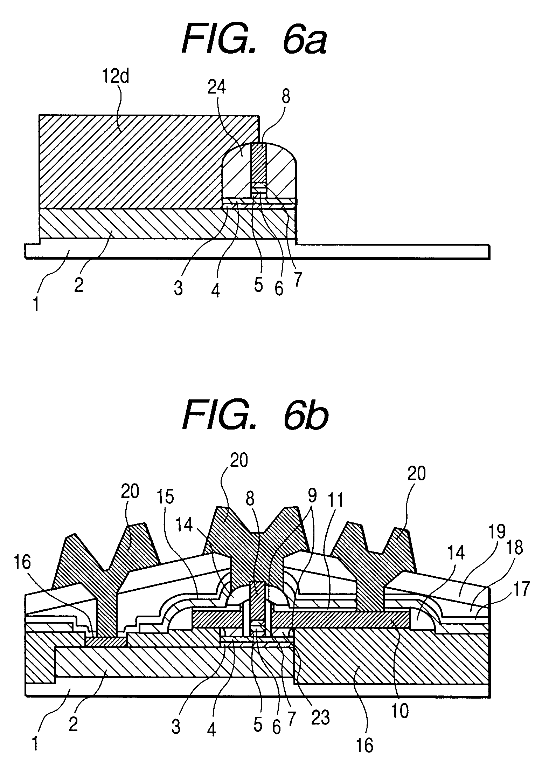

Through the same steps as Figs. 5(a) to 5(c) and the subsequent same steps as Figs. 4(e) to 4(k) there is completed such an AlGaAs/GaAs hetero-junction bipolar transistor as shown in Fig. 6(b).

In this Example, however, the inter-device isolation step of Fig. 4(i) is not necessary because the removal of the sub-collector layer 2 also serves as the inter-device isolation step.

According to this Example, since the polyimide resin film 25 lower in specific inductive capacity than the SiO₂ film 22 is formed not only in the parasitic collector region but also in the sub-collector region, it is possible to fabricate a super high-speed hetero-junction bipolar transistor decreased in base-collector parasitic capacitance to about five sevenths and increased in maximum oscillation frequency to about 1.2 times as compared with the structure of Example 3. Further, the amorphous undoped GaAs layer 15 formed in the dielectric interlayer area permits such hetero-junction bipolar transistor to be fabricated in a high process yield without causing the problems of emitter-base short-circuit and breaking of the wiring metal.

Although in Examples 1 to 4 the amorphous undoped GaAs layer 15 was formed in the dielectric interlayer area, the same layer is not always required to be amorphous, but may be polycrystalline or a mixture of amorphous and polycrystalline substances. Further, the layer in question may be a polycrystalline or amorphous compound semiconductor layer of another material, say, AlGaAs.

Although in Examples 1 to 4 reference was made to manufacturing methods for hetero-junction bipolar transistors of AlGaAs/GaAs system, there also may be used other III-V compound semiconductors such as InGaAs/InGaAs and InP/InGaAs. In this case, the structure of the base layer may utilize a two-dimensional electron gas. As to the impurity in the base layer, C may be substituted by Be. The AlAs mole ratio in the emitter layer may be selected arbitrarily in the range of 0 to 1. Although the emitter and the collector were made n-type and the base p-type, the emitter and the collector may be made p-type and the base n-type. Although the collector was formed on the substrate side and the emitter formed above, the emitter may be formed on the substrate side and the collector formed above. Although SiO2 film or polyimide resin film was used in the parasitic collector region, there may be used any other insulating film, say, Si₃N₄ film. Further, although GaAs(100) plane was used as the substrate, it goes without saying that there may be used any other material or crystal orientation.

### Example 5

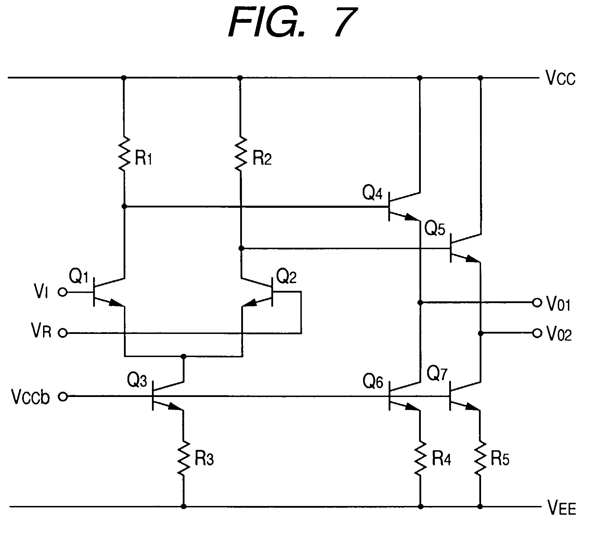

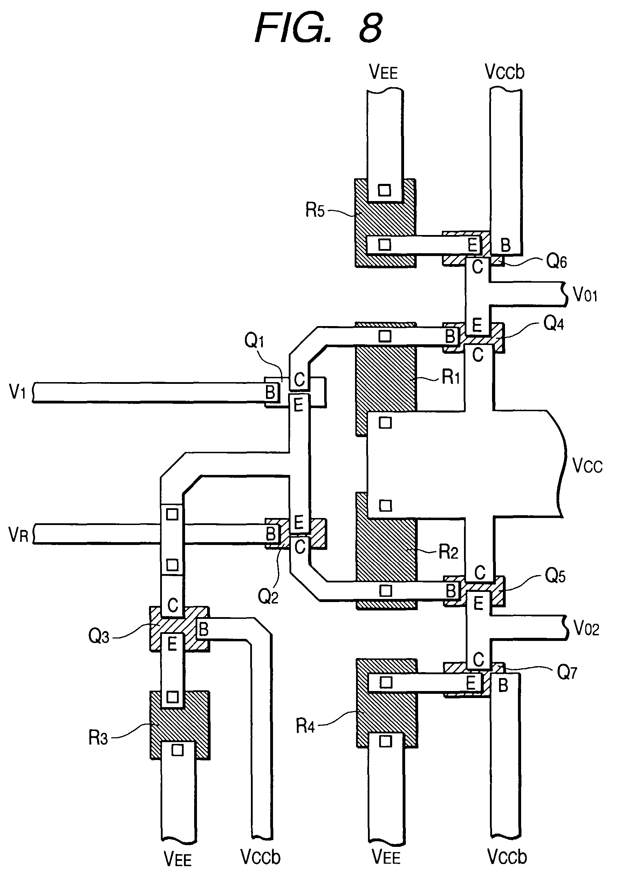

A differential amplifier circuit using any of the AlGaAs/GaAs hetero-junction bipolar transistors described in Examples 1 to 4 will be described below with reference to Figs. 7 and 8. Fig. 7 is a circuit diagram and Fig. 8 is a circuit layout diagram.

In these figures, Q1 to Q7 denote hetero-junction bipolar transistors, E, B and C in Q1 to Q7 denote emitter, base and collector, respectively, R1 to R5 denote resistors, Vi denotes an input voltage, V01 and V02 denote output voltages, Vcc denotes a power-supply voltage, VEE denotes an earth potential, VR denotes a reference voltage, and Vccb denotes a constant voltage.

According to this Example, a differential amplifier circuit capable of performing a super high-speed operation can be realized in a high integration degree. Also, it is possible to realize an electronic circuit system using such a differential amplifier circuit as a basic unit.

Although the differential amplifier circuit of this Example uses a hetero-junction bipolar transistor of AlGaAs/GaAs system, there may be used a hetero-junction bipolar transistor of another III-V compound semiconductor such as, for example, InAlAs/InGaAs or InP/InGaAs system.

### Example 6

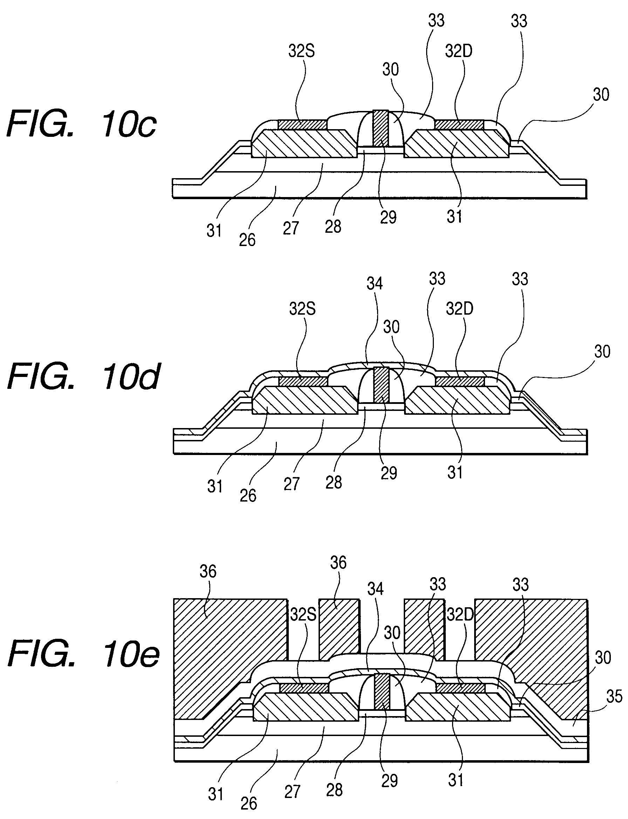

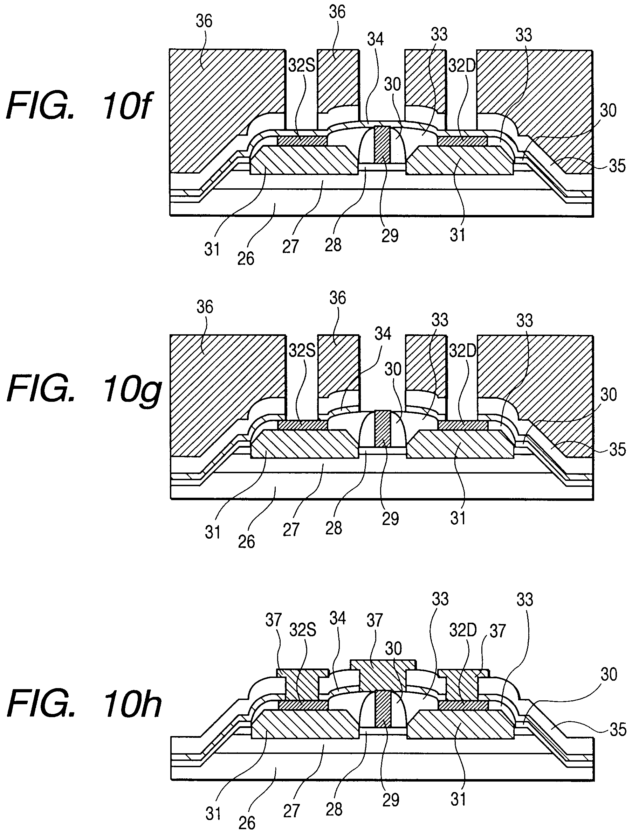

A hetero-insulated gate field effect transistor in Example 6 in the present invention will be described below with reference to Fig. 10.

First, a p-type GaAs layer 27 (Be concentration 3x10¹⁶/cm³, thickness 300 nm), a heavily doped n-type GaAs channel layer 28 (Si concentration 5x10¹⁸/cm³, thickness 20 nm), an undoped AlGaAs layer 28 (AlAs mole ratio 0.3, thickness 50 nm), and an undoped GaAs layer 28 (thickness 5 nm), were formed successively on an undoped GaAs(100) substrate 26 by epitaxial growth. Thereafter, by photolithography and etching, the substrate 26 was exposed to effect inter-device isolation. Subsequently, a gate electrode 29 of WSi having a height of 700 nm was formed. [Fig. 10(a)]

Next, SiO₂ was deposited on the whole surface, and by photolithography and dry etching, the resultant SiO₂ film was allowed to remain partially, including side walls 30 (side wall length 0.3 µm). With these SiO₂ portions as mask, the epitaxial crystal surface was etched 90 nm to expose side faces of the channel layer 28. Thereafter, in this etching area was selectively formed a heavily doped n-type GaAs layer 31 (Si concentration 4x10¹⁸/cm³, thickness 250 nm) for making the source and drain regions low in resistance, by a selective metal-organic chemical vapor deposition method. The heavily doped n-type GaAs layer 31 is connected to the side faces of the channel layer 28. On these layers were then formed an AuGe source electrode 32S and an AuGe drain electrode 32D. [Fig. 10(b)]

Next, SiO₂ was deposited on the whole surface, and SiO₂ side walls 33 were formed for the gate electrode 29 by dry etching. [Fig. 10(c)]

Then, within a molecular beam epitaxy system, undoped GaAs was deposited to a thickness of 50 nm at a substrate heating temperature of 350°C, affording a polycrystalline layer 34.
[Fig. 10(d)]

Next, SiO₂ film 35 was formed by deposition throughout the whole surface, and a resist mask 36 for forming contact holes was formed by photolithography. [Fig. 10(e)]

Then, the SiO₂ film 35 was subjected to dry etching by the RIE method using C₂F₆ gas and CHF₃ gas in a selective and anisotroplc manner for the polycrystalline undoped GaAs layer 34. [Fig. 10(f)]

Next, the polycrystalline undoped GaAs layer 34 was subjected to dry etching by the ECR method using SiCl₄ gas in a selective and anisotropic manner for the gate electrode 29 and SiO₂ side walls 30, 33, allowing the gate electrode 29 to be exposed. At this time, contact holes were formed also on the source and drain electrodes in the same manner. [Fig. 10(g)]

Then, wiring metal 37 as a low-resistance metal was deposited and subjected to ion milling for wiring to afford a hetero-insulated gate field effect transistor. [Fig. 10(h)]

According to this Example, a hetero-insulated gate field effect transistor can be fabricated in a high process yield without causing the problem of gate-source or gate-drain short-circuit even in the case of a fine device structure wherein the gate electrode width is 0.3 µm and the distance from the gate electrode to the source and drain regions is 0.3 µm.

Although in this Example the polycrystalline undoped GaAs layer 34 was used in the dielectric interlayer area, the same layer is not always required to be polycrystalline. It may be amorphous or a mixture of polycrystalline and amorphous substances. Further, the layer in question may be a polycrystalline or amorphous compound semiconductor of another material, say, AlGaAs. Although in this Example reference was made to a hetero-insulated gate field effect transistor, the present invention is also applicable to other field effect transistors such as HEMT (High Electron Mobility field effect Transistor), MESFET (Metal Schottky field effect Transistor), and a field effect transistor of MIS (metal-insulator-semiconductor) structure. Further, as the substrate material there may be used any of various other materials, including compound semiconductors and single-element semiconductors, say, Si semiconductor.

### Example 7

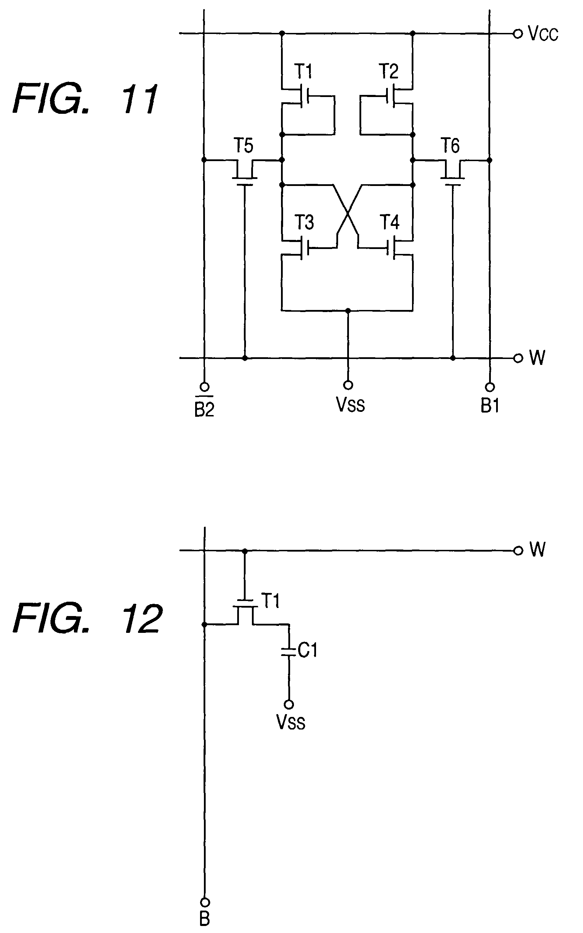

A static type random access memory cell using the hetero-insulated gate field effect transistor of Example 6 will be described below with reference to Fig. 11 which is a circuit diagram of the memory cell.

T1 to T6 denote hetero-insulated gate field effect transistors, Vcc denotes a power-supply potential, Vss denotes an earth potential, W denotes a word line, and B1 and B2 denote bit lines. The voltage of B1 and that of B2 are opposite in polarity.

According to this Example a highly reliable memory cell circuit can be realized in a high integration degree, and it is also possible to fabricate an electronic circuit system using such memory cell circuit as a basic unit.

### Example 8

A dynamic type random access memory cell using the hetero-insulated gate field effect transistor of Example 6 will be described below with reference to Fig. 12 which is a circuit diagram of the memory cell.

T1 denotes a hetero-insulated field effect transistor, Cl denotes a capacitor for storage, Vss denotes an earth potential, W denotes a word line, and B denotes a bit line.

According to this Example a highly reliable memory cell circuit can be fabricated in a high integration degree, and it is also possible to fabricate an electronic circuit system using such memory cell circuit as a basic unit.

Although in each of Examples 7 and 8 was described a memory cell circuit using hetero-insulated field effect transistor, it goes without saying that there may be used any other field effect transistor.

The present invention is also applicable to other semiconductor devices such as light emitting devices and light receiving devices than those described in the above Examples, and further applicable to integrated circuits and electronic circuits using such semiconductor devices.

## Claims

1. A semiconductor device including:
a single crystal semiconductor layer;
a first conductor layer formed on said single crystal semiconductor layer;
a first dielectric Si alloy layer formed on each side face of said first conductor layer;
a first semiconductor layer of a polycrystalline or amorphous undoped III-V compound semiconductor, or an alloy thereof, formed on said first dielectric Si alloy layer and having a through hole to which are exposed at least part of said first conductor layer and said first dielectric Si alloy layer; and
a second conductor layer formed in contact with said first conductor layer within said through hole.

2. A semiconductor device according to claim 1, wherein said III-V compound semiconductor is GaAs.

3. A semiconductor device according to claim 1, wherein said single crystal semiconductor layer includes collector, base and emitter regions of a bipolar transistor, said first conductor layer is a collector electrode or an emitter electrode, and which further includes a second dielectric Si alloy layer formed on said first semiconductor layer, said second dielectric Si alloy layer having a through hole whose inner peripheral shape is substantially coincident with that of the through hole formed in said first semiconductor layer.

4. A semiconductor device according to claim 3, wherein said III-V compound semiconductor is GaAs.

5. A semiconductor device according to claim 3, wherein said first conductor layer is an emitter electrode, said single crystal semiconductor layer further includes a sub-collector region formed on said collector region on the side opposite to said base region, the collector region and the base region are smaller than said sub-collector region, said emitter region is smaller than the collector region and the base region, and which further includes a dielectric layer formed on said sub-collector, collector and base regions and having a through hole on said base region, a base lead-out semiconductor layer of the same conductivity type as said base region, said base lead-out semiconductor layer being formed in contact with the base region within the through hole of said dielectric layer, and a base electrode formed in contact with said base lead-out semiconductor layer and extending onto said dielectric layer.

6. A semiconductor device according to claim 5, wherein said III-V compound semiconductor is GaAs.

7. A semiconductor device according to claim 5, wherein said bipolar transistor is a hetero-junction bipolar transistor constituted by a compound semiconductor and whose emitter-base junction is a hetero-junction, and said base lead-out semiconductor layer is constituted by a compound semiconductor layer.

8. A semiconductor device according to claim 7, wherein said III-V compound semiconductor is GaAs.

9. A semiconductor device according to claim 1, wherein said single crystal semiconductor layer includes a channel area of a field effect transistor, said first conductor layer is a gate electrode, and which further includes a second dielectric Si alloy layer formed on said first semiconductor layer, said second dielectric Si alloy layer having a through hole whose inner peripheral shape is substantially coincident with that of the through hole formed in said first semiconductor layer.

10. A semiconductor device according to claim 9, wherein said III-V compound semiconductor is GaAs.

11. A semiconductor device according to claim 9, wherein said field effect transistor is constituted by a compound semiconductor.

12. A semiconductor device according to claim 11, wherein said III-V compound semiconductor is GaAs.

13. A semiconductor device having a structure of a bipolar transistor wherein sub-collector region, collector region, base region and emitter region are laminated in this order, said collector region and said base region being smller than said sub-collector region, said emitter region being smaller than said collector region and said base region, said semiconductor device further including a dielectric layer formed on said sub-collector, collector and base regions and having a through hole on said base region, a base lead-out semiconductor layer of the same conductivity type as said base region, said base lead-out semiconductor layer being formed in contact with said base region within the through hole of said dielectric layer, and a base electrode formed in contact with said base lead-out semiconductor layer and extending onto said dielectric layer.

14. A semiconductor device including a dielectric Si alloy layer and a semiconductor layer of a polycrystalline or amorphous undoped III-V compound semiconductor or an alloy thereof, with a through hole being formed in said semiconductor layer.

15. A semiconductor device according to claim 14, wherein said III-V compound semiconductor is GaAs.

16. A method for manufacturing a semiconductor device, including the steps of:
forming a first conductor layer on a single crystal semiconductor layer;
forming a first dielectric Si alloy layer on each side face of said first conductor layer so that an upper surface of the first conductor layer is exposed;
forming a first semiconductor layer of a polycrystalline or amorphous undoped III-V compound semiconductor or an alloy thereof on said first dielectric Si alloy layer and said first conductor layer;
forming a second dielectric Si alloy layer on said first semiconductor layer;
forming a first through hole in said second dielectric Si alloy layer so as to reach said first semiconductor layer in accordance with a selective dry etching method for the first semiconductor layer, using a reactive gas;
forming a second through hole in said first semiconductor layer so as to reach at least part of said first conductor layer and said first dielectric Si alloy layer present around the first conductor layer in accordance with a selective dry etching method for the first conductor layer and the first dielectric Si alloy layer, using a reactive gas and using as etching mask said second dielectric Si alloy layer having said first through hole; and
forming a second conductor layer so as to contact said first conductor layer within a through hole constituted by said first and second through holes.

17. A method according to claim 16, wherein GaAs is used as said III-V compound semiconductor.

18. A method according to claim 16, wherein said first semiconductor layer is formed while heating a substrate at a temperature of not higher than 400°C in accordance with a thin film forming method selected from molecular beam epitaxy method, metal-organic chemical vapor deposition method, metal-organic chemical molecular beam epitaxy method, and sputtering method.

19. A method according to claim 17, wherein GaAs is used as said III-V compound semiconductor.

20. A method according to claim 16, wherein said single crystal semiconductor layer includes a semiconductor layer of a compound semiconductor containing In, and which further includes the step of etching said semiconductor layer in a mixed gas atmosphere of Cl₂ and CH₄ at a pressure of not higher than 40mPa in accordance with a microwave etching method.

21. A method for manufacturing a semiconductor device, including the steps of:
forming a semiconductor layer of a polycrystalline or amorphous undoped III-V compound semiconductor or an alloy thereof on a dielectric Si alloy layer; and
forming a through hole in said semiconductor layer in accordance with a selective dry etching method for said dielectric Si alloy layer, using a reactive gas.

22. A method according to claim 21, wherein GaAs is used as said III-V compound semiconductor.
